# EUROPEAN PATENT APPLICATION

(11) **EP 2 957 654 A1**
(43) Date of publication of application: **23.12.2015**
(21) Application number: 14751166.1
(22) Date of filing: 12.02.2014
(51) Int. Cl.: C23C 14/06, F16C 33/24

(54) **SLIDING MEMBER**

(30) Priority: 12.02.2013 JP 2013024852
(71) Applicant: Kayaba Industry Co., Ltd., Tokyo 105-6111 (JP); Bam Federal Institute for Materials Research and Testing, 12205 Berlin (DE)
(72) Inventor: WOYDT, Mathias, DE12200 Berlin (DE); WAESCHE, Rolf, DE12200 Berlin (DE); KOEHLER, Norbert, DE12200 Berlin (DE); TAMURA, Tetsuya, Tokyo 105-6111 (JP); HOSOHATA, Shuhei, Tokyo 105-6111 (JP); KATO, Shinji, Tokyo 105-6111 (JP); NAKASE, Takuya, Tokyo 105-6111 (JP)
(74) Representative: TBK
(86) International application number: PCT/JP2014/053127
(87) International publication number: WO 2014/126080

(57) **Abstract**

Problems to be solved: To provide a sliding member capable of achieving low friction properties and low wearing properties under dry conditions (i.e., in the absence of a lubricant).

Solution: A sliding member including: a sliding-element 1; and a sliding-element 2 which serves as a counterbody to the sliding-element 1, in which the sliding-element 1 is made of oxide ceramics and the sliding-element 2 is made of a thin film containing hydrogen and sp³/sp²-hybridized carbon. Advantages: The sliding member achieves low friction properties and low wearing properties and in which the friction coefficient is unrelated to the sliding speed.

## Description

### Technical Field

The present invention relates to a low-friction sliding member in the dry friction condition. More specifically, the present invention relates to a sliding member which is capable of obtaining a sufficient low friction coefficient even in the absence of a lubricant and, at the same time, is not substantially worn, or relates to a sliding member which is capable of practically operating without using lubricating oil in mechanical components for which wear resistance is required.

### Background Art

In recent years, a low friction sliding member has been required in order to respond to social applications such as energy loss due to frictional force derived from a portion in which sliding of a member occurs, consumption of components due to wear, and environmental pollution due to worn members, and energy saving of the power machinery, and thus tribology have been attracting attention for solving these requirements.

Tribology plays an important role in key industries of Japan. For example, in the automotive industry, currently, various efforts have been made with the aim of reducing the amount of carbon dioxide emitted from automobiles for the purpose of conservation of the global environment. However, in order to further reduce fuel consumption, not only development of power sources but also reduction of transmission loss of energy caused by friction in the engine interior and the driving system have become important. It is recognized that reduction of the friction coefficient of sliding members in power system equipment and improvement of wear resistance are important, and thus amorphous hard carbon materials (DLC) have been attracting attention as new materials constituting low frictional surfaces of sliding members made of structural steel or high alloy steel. In achieving improvement of fuel consumption efficiency, it is necessary to reduce frictional loss in automotive drive system units such as engines, transmissions, and reduction gears.

The fields of technology for which reduction of friction and reduction of friction loss are required, microelectronics, integrated circuits (IC), micro controllers, digital memory chips, memory chips, small electronic circuits, and microchips are exemplified. They are produced in a clean room and the dust concentration or environmental pollutant concentration in the air is kept extremely low. This is because microelectronics or chips are easily affected by contamination of particles, dust, or aerosols. Equipment or mechanical devices in a clean room generate fine particles by the friction and a lubricant or a fluid generates steam or aerosols of chemical substances, but the environment in the clean room is improved and air pollution can be minimized when wear due to friction is resolved. In addition, when fine particles contaminate a system containing oxygen, the system becomes more vulnerable to fire hazard because the surface area of the fine particles is large and thus even low energy may cause a fire. The system containing oxygen, such as adiabatic compression, resonance, solid friction, fluid friction, and promoted ignition are exemplified as sources of ignition. That is, a sliding system with no friction and no fine particles generated due to friction, is safe even in a system with a high oxygen concentration (that is, fill valves, shut-off valves, residual pressure valves, regulator, or relief valves in medical or industrial equipment).

In the related art, as materials having characteristics of a low friction coefficient, powders or a sintered body of solid lubricants, such as graphite, molybdenum disulfide, or boron nitride, or having a layered crystal structure with small shear resistance are known, but various hard thin films have been extensively studied because of requirements of low friction and wear resistance in a harsh environment in which lubricating oil is unlikely to be used.

For example, in sliding members made of structural steel or a high alloy steel, in order to realize an improvement of wear resistance or a low friction coefficient, various techniques of coating an amorphous hard carbon (hereinafter, also referred to as DLC or diamond-like carbon) film using various surface treatments have been suggested. The amorphous hard carbon film is used as a protective film that provides wear resistance for tools, molds, magnetic heads, or magnetic disks. This usage is derived from the fact that the amorphous hard carbon film has high hardness. However, in regard to the usage as the surface treatment of a sliding material, that is, the usage as a lubricating film, attempts of usage in lubricating oil or under conditions in which lubricating oil is mediated has been made in rare cases.

As sliding members using hard carbon films, for example, a sliding member (PTL 1) in which friction loss at a sliding-surface is further reduced even under unlubricated conditions or a friction environment with limited oil films compared to a low friction material such as isotropic graphite of the related art, a surface made of highly oriented specific graphite whose half width at a rocking curve in a graphite-2H002 diffraction position is 7° or less using X-ray diffraction measurement and a surface made of an alloy of highly oriented specific graphite with excellent wear resistance are provided parallel to a sliding direction toward the sliding direction in a portion of a skirt portion which is a sliding-surface when a sliding member having excellent wear resistance compared to a case where highly oriented graphite is used in the entire sliding-surface is provided; a sliding component (PTL 2) which exhibits wear resistance with respect to a specific slurry or pure water, does not show a squealing phenomenon in low friction, does not show torque fluctuation, forms a diamond-like carbon film on a sliding-surface of a hard material, and specifies the thickness of the diamond-like carbon film; and a rolling instruction device (PTL 3) which is a rolling support device which has excellent lubricating performance for a long period of time even when used in a vacuum and in which a diamond-like carbon layer which is made of hydrogen (H) and carbon (C) and whose content of hydrogen is in the range of 40 atomic% to 53 atomic% is made on a raceway surface of an inner ring and an outer ring and a polyethylene spacer is arranged between balls have been suggested.

It is needless to say that obtainment of a sliding member which does not need lubricating oil brings many advantages. For example, the sliding member is used in a manufacturing process of microelectronics and integrated circuits (IC) in which dust concentration or environmental contaminant concentration needs to be suppressed. As a dry sliding member which does not use a lubricant as described in PTL 1, the use of an amorphous hard carbon film or a carbon nitride film as a lubricating film is suggested, but the influence of oxygen becomes a huge problem. Since the carbon atoms of an amorphous hard carbon film are easily combined with oxygen in the air, when they are used in the air, oxidation advances gradually. It is known that an amorphous hard carbon film or a carbon nitride film cannot be used for a long period of time and has degraded durability due to the problem of oxidation when practically used in air.

Here, as a solution of oxidation in the air, for example, a sliding device (PTL 4) in which a carbon nitride film is made on a sliding-surface of at least one member between two members which slide facing each other and the sliding-surface is substantially configured to have a nitrogen gas atmosphere, or a sliding unit (PTL 5) which is capable of improving wear resistance and reducing the friction coefficient in the air even under the dry friction conditions by including a pair of sliding members in which an amorphous hard carbon film, a carbon nitride carbon film (CNx film), or a diamond coated hard carbon film is made on a sliding-surface of at least one sliding member between sliding members sliding each other and voltage applying means for applying a voltage to a space between sliding-surfaces of the pair of sliding members has been suggested. However, they have not solved the problems of using amorphous hard carbon as a material which reduces the sliding friction coefficient or wear properties the dry friction conditions.

In the related art, as a method of forming an amorphous hard carbon film, a plasma CVD method is generally used. This is a method of forming an amorphous hard carbon film on a base material by introducing raw material gas into a vacuum chamber and causing active radicals or ions using high frequency discharge (for example, a capacitively coupled plasma excitation system or an inductively coupled plasma excitation system) or microwave discharge. The formation of an amorphous hard carbon film is described in many known literatures, for example, PTLs 6, 7, and 8.

### Citation List

### Patent Literature

- PTL 1:: JP-A-2010-223288
- PTL 2:: JP-A-2004-225725
- PTL 3:: JP-A-2007-56936
- PTL 4:: JP-A-2002-339056
- PTL 5:: JP-A-2007-70565
- PTL 6:: JP-A-2004-323973
- PTL 7:: JP-A-2010-126419
- PTL 8:: JP-A-2004-238696

### Summary of Invention

### Technical Problem

The present invention has been made in consideration of the problems in the related art described above and realized by continuing efforts on research and development. An object of the present invention is to realize a sliding member which achieves low friction and almost no wear at the same time under conditions of dry sliding and to achieve substantially no wear in a wide range of the sliding speed in naturally occurring environment on earth.

Typically, in a sliding system lubricated with oil, friction also varies in response to an increase in speed such as a "Stribeck curve" from boundary lubrication to fluid lubrication through mixed lubrication. Immediately after the mixed lubrication state, an oil film separating two mating surfaces is made and two surfaces are separated by the film and thus abrasive wear does not occur.

It is effective to realize a sliding system of dry running or non-lubricating oil because the design of the entire device becomes simple in dry sliding which does not need to seal an oil circuit or oil. An object of the present invention is to realize a combination of a sliding-couple that exhibits a low friction coefficient under conditions of dry sliding.

An object of the present invention is to provide a sliding member which is capable of obtaining a sufficient low friction coefficient even under dry conditions and, at the same time, which is not substantially worn in the absence of a lubricant, or to provide a sliding member which is capable of practically operating without using lubricating oil in mechanical components for which wear resistance is required.

### Solution to Problem

The present invention is configured of the following technical elements.
(1) A sliding member including: a sliding-element 1; and a sliding-element 2 which serves as a counterbody to the sliding-element 1, in which the sliding-element 1 includes a sliding-surface made of oxide ceramics, and the sliding-element 2 includes a sliding-surface made of a thin film containing hydrogen and sp³/sp²-hybridized carbon.
(2) The sliding member according to (1), in which tribological overlap ratios of the sliding-element 1 and the sliding-element 2 are 100% in the sliding-element 1 and less than 100% in the sliding-element 2.
(3) The sliding member according to (1), in which the oxide ceramics of the sliding-element 1 are a monolithic body or a thin film.
(4) The sliding member according to (1), in which the oxide ceramics of the sliding-element 1 are made of one or more of the oxide ceramics selected from stabilized zirconia, titanium dioxide containing titania of a Magneli phase, alumina, and zirconia-toughened alumina.
(5) The sliding member according to (1), in which the sliding-surface of the sliding-element 1 has a surface roughness Ra of 2.0 µm or less.
(6) The sliding member according to (1), in which the thin film of the sliding-element 2 is made of hydrogen and sp³/sp²-hybridized carbon, and sp³/(sp² + sp³) is greater than 40 atomic%.
(7) The sliding member according to (1), in which the thin film of the sliding-element 2 is amorphous hard carbon containing hydrogenated amorphous carbon.
(8) The sliding member according to (1), wherein the sliding-surface of the sliding-element 2 has a surface roughness Ra of 2.0 µm or less.
(9) The sliding member according to (1), wherein the sliding-element 2 comprises a metal base material selected from iron, steel, an iron alloy, aluminum, or an aluminum alloy and a thin film made on the surface thereof.
(10) The sliding member according to (1), in which the thin film of the sliding-element 2 includes an inclined layer which contains metal and in which the content thereof is decreased toward the surface and a surface layer made of hydrogen and sp³/sp²-hybridized carbon.
(11) The sliding member according to (1), in which the thin film of the sliding-element 2 includes an inclined layer which includes one or more metals selected from chromium, tungsten, and titanium and in which the content thereof is decreased toward the surface and a surface layer made of hydrogen and sp³/sp²-hybridized carbon.
(12) The sliding member according to (1) wherein the sliding member has properties that a friction rate or a wear rate does not depend on sliding speed.
(13) The sliding member according to (1) wherein the sliding member exhibits low friction properties and low wearing properties in an oxidizing atmosphere.

### Brief Description of Drawings

Fig. 1 shows an example of a layered structure of a sliding-element 2.
Fig. 2 shows distribution of elements on a base material (iron) 1, an inclined layer 2, and a DLC layer 3 in a cross section of the sliding-element 2.
Fig. 3 shows a TEM image of a cross section of a DLC film.
Fig. 4 shows distribution strength of elements using EDX in the cross section of the DLC film.
Fig. 5 shows distribution strength of elements shown in Fig. 4 in an enlarged view.
Fig. 6 is a conceptual diagram of a sputtering device that produces a thin film (DLC) of the present invention.
Fig. 7 shows a relationship between the sliding speed and the friction coefficient under dry sliding conditions.
Fig. 8 shows a relationship between the sliding speed and the wear rate under dry sliding conditions. Description of Embodiments

A sliding member of the present invention includes a sliding-element 1 and a sliding-element 2 which serves as a counterbody to the sliding-element 1, and the sliding-element 1 is made of oxide ceramics and the sliding-element 2 is made of a thin film containing hydrogen and sp³/sp²-hybridized carbon. The sliding member is made of a combination of sliding-elements having low friction under dry friction conditions and it is possible to replace a sliding and roller bearing guide for a sliding friction-couple of the present invention because the load carrying capacity is in the range of 100 MPa to 400 MPa under conditions of dry sliding in a sliding speed range of 0.03 m/s to 6 m/s. When the sliding member of the present invention is used, it is possible to realize a sliding member which achieves low friction and almost no wear at the same time under conditions of dry sliding and to achieve substantially no wear in a wide range of the sliding speed in naturally occurring environment on earth. In the sliding member of the present invention, when one of the sliding-couple is set to be a carbon thin film in which sp³/sp²-hybridized carbon is at a specific ratio and in a mixed state and the other is set to be oxide ceramics, surprisingly, a combination of a sliding-couple exhibiting a low friction coefficient under conditions of dry sliding is realized. The results in which unlubricated (dry) friction can be reduced by combining oxide ceramics and a specific carbon thin film are obtained using the sliding member of the present invention, and another beneficial characteristic of these sliding members is that the friction coefficient has no correlation with the sliding speed, which is advantageous, even though there are differences in degree.

The sliding member of the present invention can be used as protective films of various sliding components in automobiles such as a valve mechanism of an internal combustion engine and a drive mechanism of a fuel injection valve of a fuel delivery pump; a prototype mold, or a tool. Further, it is effective to prevent fine particles from being generated due to friction in equipment or devices to be used in a clean room in which microelectronics, integrated circuits (IC), micro controllers, digital memory chips, memory chips, small electronic circuits, microchips are produced and to keep dust concentration or environmental pollutant concentration extremely low in the air.

In the sliding member of the present invention, a sliding-element 2 whose tribological overlap ratio (tribological contact ratio) is less than 100% and a sliding-element 1 which serves as a counterbody and whose tribological overlap ratio is 100% tribologically interact each other in a closed sliding system. The sliding-element 1 is made of oxide ceramics and the sliding-element 2 is made of a base material which is coated with a thin film made of hydrogen and sp³/sp²-hybridized carbon, and it is possible to achieve substantially no wear even in a dry friction state in which a lubricant is not mediated on the contact surface of the sliding-element 1 and the sliding-element 2. The overlap ratio of the mating surface of the sliding-element 1 (or a primary sliding-element) is 100% and the mating surface is constantly in contact with the counterbody. The sliding-element 2 (counterbody) has an overlap ratio of less than 100% in all surfaces, is intermittently in contact, and periodically receives a localized contact pressure through a contact portion.

In the description of the present invention hereinafter, the "thin film made of hydrogen and sp³/sp²-hybridized carbon" is also referred to as an "amorphous hard carbon film" or a "DLC film." Further, the "amorphous hard carbon film" of the present invention includes an "inclined layer" and an "amorphous hard carbon layer."

In the sliding member, a plurality of elements can be assumed in order to achieve a low friction coefficient in a no wear state, but it is desirable to have two or more of (a) to (c) below.
(a) A smooth surface at an atomic level
(b) Small surface interaction
(c) Elastically demade fine irregularities

In order to satisfy these conditions, primarily, the material of the sliding member becomes a major factor, but, preferably, surface smoothness or the like is defined.

Next, the material of the sliding member will be described.

### [Material of sliding-element 1]

The sliding-element 1 is made of oxide ceramics and the kind thereof is not particularly limited, but it is preferable to be selected as a combination of one or more kinds from among stabilized zirconia, titanium dioxide containing titania of a Magneli phase, alumina, and zirconia-toughened alumina.

The surface roughness of the sliding-element 1 preferably has a Ra value of 2.0 or less, more preferably 0.1 µm or less, and still more preferably in the range of 0.1 µm to 0.001 µm. Further, the optimum value of Ra is in the range of 0.018 µm to 0.026 µm. The Rz value is preferably in the range of 1.0 µm to 0.1 µm and more preferably in the range of 0.5 µm to 0.05 µm. Further, the optimum value of Rz is in the range of 0.163 µm to 0.321 µm.

The stabilized zirconia is also referred to as partially stabilized zirconia. Stabilized zirconia is obtained by adding magnesium oxide (magnesia), yttrium oxide (yttria), cerium oxide (ceria), or other oxides such as oxide of an alkaline earth metal, lanthanum oxide, and oxide of a rare earth element to a crystal lattice as a stabilizer for stabilization (i.e. where phase transition is not occurred) in a cubic crystal or a tetragonal crystal since zirconia which is not stabilized causes phase transition in a high temperature range and by preventing the occurrence of cracks due to a large change in the volume caused by phase transition at a high temperature.

For example, as zirconia (PSZ) stabilized by magnesia, zirconia (ZN40, microhardness: 11080 MPa, HV0.2, a density r: 5.74 gr./cm³) which is sintered and contains 3.3% by weight of MgO is used. ZN40 is lenticular and nano-sized ZrO₂ particles in a tetragonal crystal are uniformly distributed in a ZrO₂ matrix of a cubic crystal. The structure of a phase measured using XRD (X-ray diffraction) is composed of 52% tetragonal crystals, 8% monoclinic phases (mainly, a grain boundary region), and the rest is cubic crystals. The typical average particle size is 70 µm. A stationary sample is produced by polishing MgO-ZrO₂ of a monolithic body.

As titanium oxide, TiₙO₂ₙ₋₁ and Tiₙ₋₂Cr₂O₂ₙ₋₁ of a Magneli phase are used and the temperature range in dry sliding is 400°C to 800°C. It is confirmed that the friction is reduced in the material, but is used as a sliding-element of the present invention.

As alumina (aluminum oxide), for example, it is preferable to use sintered alumina having a purity of 99.7% (A1999.7, 14740 MPa, HV0.2, density p: 3.9 gr./cm³). A stationary sample is a sintered body which is produced by polishing α-Al₂O₃ of a monolithic body and the average particle size is in the range of 2 µm to 8 µm.

Zirconia toughened alumina is toughened alumina which is obtained by adding zirconia to alumina and being sintered in a compact manner and is a material which has high mechanical strength and fracture toughness compared to alumina of the related art and is used as a cutting tool of an impact resistant member or a wear resistant member.

### [Material of sliding-element 2]

The sliding-element 2 of the present invention is made of a thin film containing hydrogen and sp3/sp2-hybridized carbon, the thin film is made of an amorphous hard carbon layer which is also referred to as diamond-like carbon (DLC), and the structure thereof includes hydrogenated amorphous carbon (a-C:H). For example, when the layer is made, solid carbon (graphite) is considered as a target source of sputtering and a film is made by mediating methane gas (CH₄) and hydrogen (H₂) at the same time.

In the surface roughness of the sliding-element 2, Ra is preferably 2.0 µm or less, more preferably in the range of 0.5 µm to 0.0001 µm, and still more preferably in the range of 0.05 µm to 0.0005µm. Further, Rz is preferably in the range of 0.1 µm to 0.01 µm and more preferably in the range of 0.05 µm to 0.01 µm.

The surface roughness of a base material before an amorphous hard carbon film is made is 0.5 µm or less, preferably 0.05 µm, and still more preferably 0.01 µm.

Further, it is preferable to provide amorphous hard carbon thin film coating having characteristics related to (a) to (c) below.
(a) The indentation modulus (equivalent to the elastic modulus) is lower than the indentation modulus of steel.
(b) At a deposition stage, roughness is extremely low.
(c) A high content (for example, sp³/(sp² + sp³) = 51% in the measurement value) of sp³-hybridized carbon is contained.

When an amorphous hard carbon film is made on the surface of a base material, the film is directly provided on the surface thereof. However, it is preferable to include an inclined layer (bond layer) in which metal such as chromium, tungsten, or titanium is contained, and it is more preferable that the inclined layer has an increased content of metal on the base material side and the composition thereof is allowed to be closer to the composition of amorphous hard carbon such that the content of metal is reduced to a surface amorphous hard carbon layer, and the surface is changed to a pure amorphous hard carbon layer.

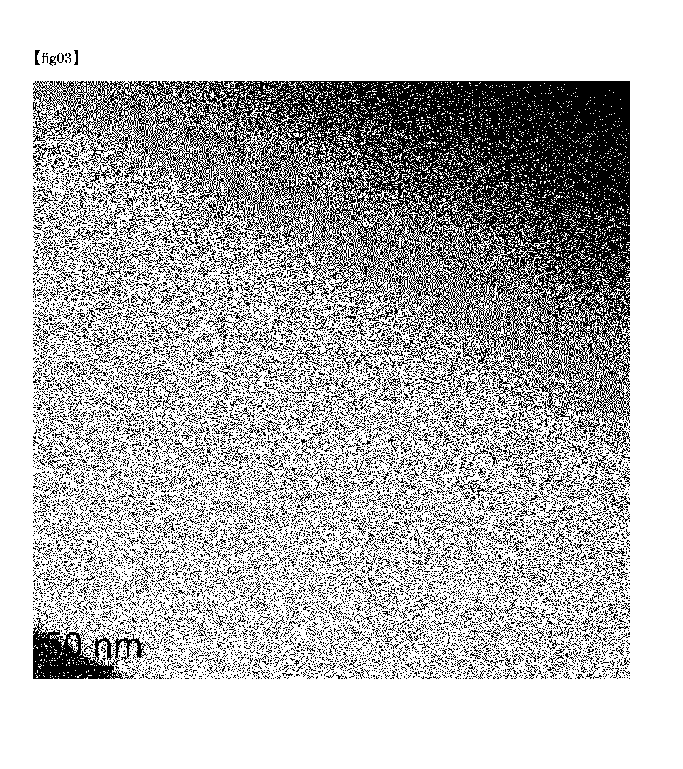

When the amorphous hard carbon thin film provided on the surface of the sliding-element 2 is not subjected to machining or a surface treatment after deposition and the surface roughness is measured using a stylus type surface shape measuring device (stylus plofilometer) (HOMMEL T8000, stylus tip TKL100 with 60° and 2 µm), the values of Ra, Rpk, and Rvk are respectively 0.005 µm, 0.006 µm, and 0.012 µm. The surface roughness can also be calculated from a 2D topography image measured using an atomic force microscope (AFM) (manufactured by Asylum Corp.) and RMS is 2.53 nm (0.00253 µm) and Ra is 1.98 nm (0.00198 µm) when the root mean square roughness (RMS) is measured. This extremely low surface roughness indicates an extremely large nuclear generation rate at the time of deposition of primary particles. In this manner, the state thereof becomes an amorphous aggregation state as shown in Fig. 3.

Table 1 shows an example of characteristics of the amorphous hard carbon thin film made on the surface of the base material in the sliding-element 2 of the present invention. When hydrogen components are measured using ERDA (Elastic Recoil Detection Analysis), the value thereof is 16 atomic%.

**[Table 1]**

| Coating name | Ratio sp2/(sp2 + sp3)* | Coating type | Coating thickness [µm] | Adhesion layer | Process type | Hardness+ [GPa] | Indentation Modulus+ [GPa] |
|---|---|---|---|---|---|---|---|
| KYB type A | 0.49 | a-C:H | 1.0 | Cr-C | Physical vapor deposition (PVD) | 13 | 139 |

| | | | | | | | |
|---|---|---|---|---|---|---|---|
| * Absorption near-edge X-ray absorption fine structure (NEXAFS); +Naindenda: ELIONIX ENT-100a, weight: 9.8 mN; PVD: physical vapor deposition | | | | | | | |

### [Structure of amorphous hard carbon film]

It is preferable that the amorphous hard carbon film made on the surface of the sliding-element 2 has a metastable form of amorphous carbon (a-C) and hydrogenated amorphous carbon (a-C:H) and sp³/(sp² + sp³) has a hybridized rate of 40 atomic% to 55 atomic% and contains hydrogen components in the range of 10 atomic% to 20 atomic%. In a normal a-C:H thin film, the ratio of sp³/(sp² + sp³) carbon components is smaller than 40 atomic%, and a two-phase model of an amorphous carbon thin film which is widely used has a graphite like cluster in a sp³ base material or a nanocrystalline two-phase structure.

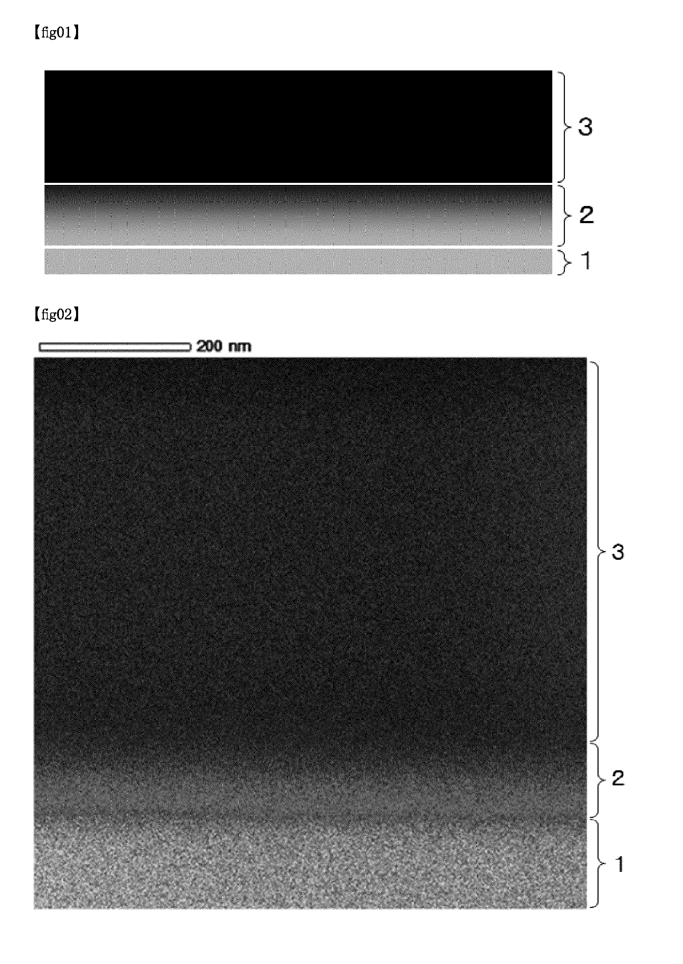

Fig. 1 shows a layered structure which is a specific example of the sliding-element 2. In the sliding-element 2, an amorphous hard carbon layer 3 is provided on the surface of a metal 1 which is a base material through an inclined layer 2. The amorphous hard carbon layer 3 of the surface does not contain metal. The inclined layer 2 is referred to as an intermediate layer or a bond layer and plays a role of strongly bonding the amorphous hard carbon layer to the surface of the metal which is a base material, and the inclined layer contains metal and amorphous hard carbon and has a composition that is close to that of the amorphous hard carbon as separated from the surface of the metal. The composition of the surface of the base material of the intermediate layer may be made of 100% of metal components or may be made of amorphous hard carbon containing metal components. The metal components of the inclined layer 2 are selected from chromium, tungsten, and titanium.

When the cross section of the intermediate layer of the amorphous hard carbon film of one embodiment of the present invention is observed using transition electron microscopy (TEM), the sum of the amorphous hard carbon layer and the intermediate layer is in the range of 0.6 µm to 3 µm and the thickness of the amorphous hard carbon layer is preferably 540 nm. There are no holes or voids between the base material and the amorphous hard carbon film. The layer made of chromium metal is approximately 50 nm and the thickness of a portion where the concentration of metal is inclined in the intermediate layer is approximately 100 nm. Nano crystals are dispersed in an amorphous matrix area in the intermediate layer. In this manner, the metal components in the intermediate layer are gradually decreased until the components become an amorphous hard carbon layer in an amorphous form.

Fig. 2 shows element distribution on the cross section of the amorphous hard carbon film which is an example of the present invention for which the amorphous hard carbon layer 3 is provided through the inclined layer 2 made of a chromium element and amorphous hard carbon on the surface of a steel material 1 (Cronidur 30) whose surface is nitrided. In the inclined layer 2, it can be clearly understood that metal elements are decreased toward the amorphous hard carbon layer from the tone of light and shade. It is understood that a portion which is transitioned from an inclined layer to an amorphous hard carbon layer and an amorphous hard carbon layer have an amorphous form from measurement using X-ray (XRD) or electron beams (TEM). This is shown in Fig. 3. The amorphous hard carbon layer does not contain impurities such as carbide.

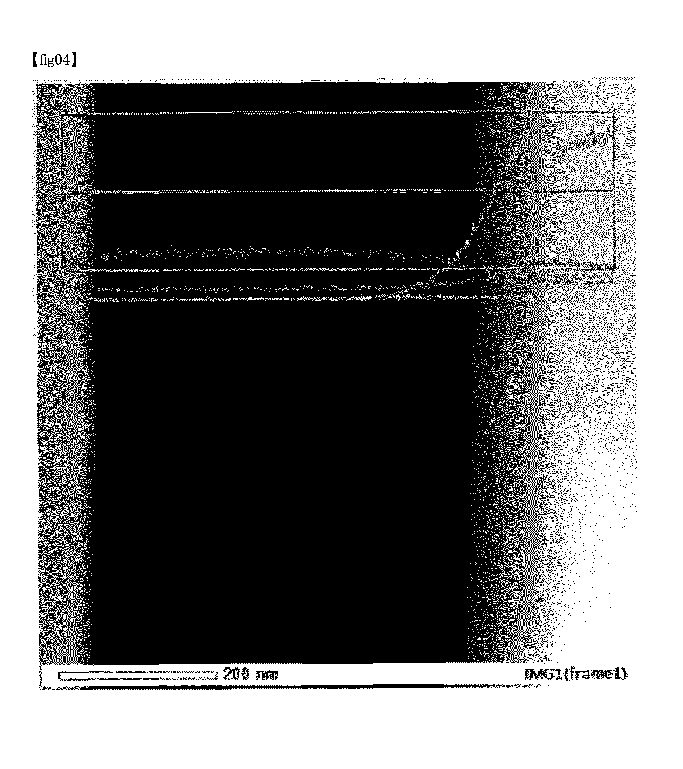

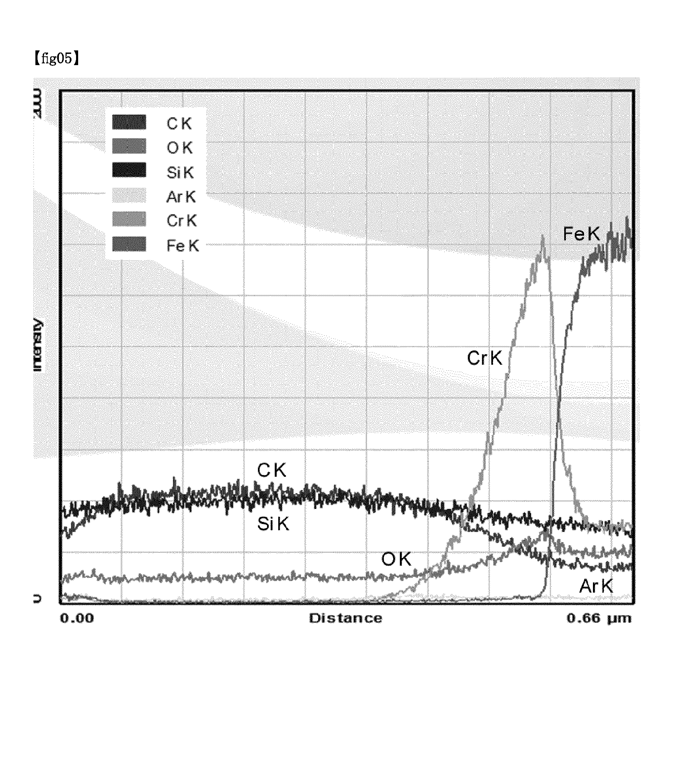

Fig. 4 shows element distribution on the cross section of the amorphous hard carbon film of the present invention for which the amorphous hard carbon layer 3 is provided through the inclined layer 2 made of a chromium element and amorphous hard carbon on the surface of the steel material 1 (Cronidur 30) whose surface is nitrided. The black portion indicates the amorphous hard carbon layer. The details of element distribution on the cross section are shown in Fig. 5. Measurement is made using JEM 2200 at 200 kv, and Fe, OK, SiK, ArK, and CrK respectively represent iron, oxygen, silicon, argon, and chromium. Fig. 5 clearly shows that the chromium element is gradually decreased from the surface of the base material and is continuous in the amorphous hard carbon layer.

### [Formation of amorphous hard carbon film]

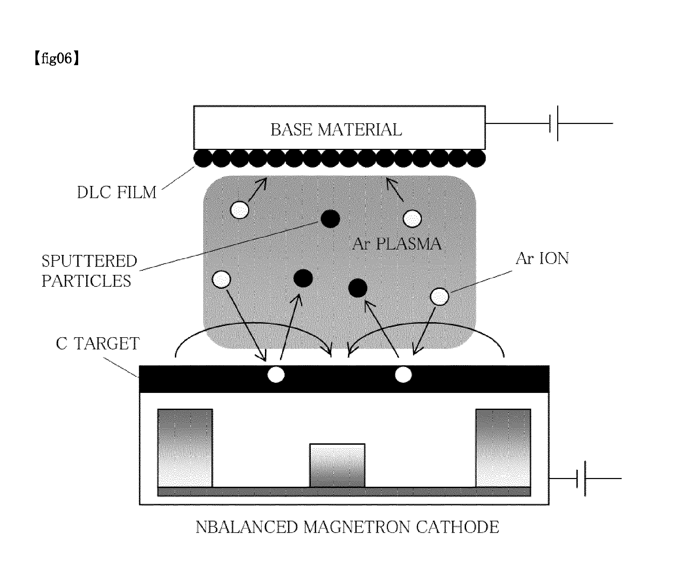

As shown in Fig. 6, the principle of sputtering for forming the amorphous hard carbon film is achieved by a magnetron sputtering method of forming plasma using a target as a cathode in a vacuum to which sputtering gas such as argon (Ar) is introduced to be glow discharged between anodes, allowing ions in the plasma to collide with the target to flip atoms of the target, and depositing the atoms on a metal workpiece which is arranged so as to face the target to form a film. In addition, when an amorphous hard carbon film is made, hydrocarbon gas such as methane (CH₄) or hydrogen gas (H₂) is used together with sputtering gas in order to control the amount of hydrogen into the amorphous hard carbon.

The base material is cleaned by argon etching after being heated. In the magnetron sputtering method described above, vapor deposition is carried out under the following conditions.
(a) Carbon/graphite cathode output: 12 kW × 4 cathode
(b) Ratio of argon to methane (CH₄): 10:3, gas partial pressure: 0.4 Pa
(c) Temperature of base material during vapor deposition: 270°C

The amorphous hard carbon film of the present invention which is made on the base material as the sliding-element 2 is amorphous carbon containing hydrogen and is made of sp³/sp² hybridized carbon and the value of sp³/ (sp² + sp³) is preferably in the range of 40 to 55. The value of sp³/ (sp² + sp²) is measured by a method described in "Foundation of internal structure of DLC" written by Kazuhiro Kanda, University of Hyogo in Advanced Industry Science and Technology Institute, p. 35 to 45, in the first seminar of New Diamond Forum 2008 on October 17, 2008.

An inclined layer is made by sputtering a metal target of an evaporation source and a graphite target of a sputter evaporation source at the same time, gradually changing a target output to proportionally reduce a metal target output of the sputter evaporation source to be made as an inclined composition film of metal and carbon with time, proportionally increasing a graphite target output of the sputter evaporation source with time, and performing sputtering for a predetermined period of time. Further, the amorphous hard carbon film is made on the surface when the output of the graphite target becomes 100%.

### [Material of base material]

The sliding-element 2 includes a base material and an amorphous hard carbon thin film made on the surface thereof and is preferably provided with an inclined layer made of metal and carbon. The base material is not particularly limited as long as physical properties as a mechanical component are satisfied, but is usually made of metal. As the metal, various steels such as stainless steel, iron alloys, aluminum, or alloys thereof are used. In order to form a smooth amorphous hard carbon thin film on the surface of the base material, the surface of the base material has a value of Ra of 0.01 µm or less.

Steels in which the surface of the base material is annealed at 200°C or higher or steel materials which are subjected to a carburizing treatment, a nitriding treatment, or a thermochemical treatment such as nitriding and carburizing nitriding are used. Further, in a case where a metal aluminum alloy is used as a base material, it is preferable that the surface thereof is conversion-coated.

### [Smoothness of surfaces of sliding-element 1 and sliding-element 2]

The sliding member of the present invention can achieve low friction and low wear properties (no wear) in a dry friction state by selecting the sliding-element 1 and the sliding-element 2 from specific materials, but it is preferable that the surface of each element is smooth. Ra is preferably 0.1 µm or less in the sliding-element 1 (ceramics) and Ra is preferably 0.1 µm or less in the sliding-element 2 (amorphous hard carbon). Adjustment of surface roughness of ceramics can be achieved by purchasing a commercially available product or applying a molding technique and a polishing technique of the related art. Moreover, adjustment of the surface roughness of the amorphous hard carbon film is permade by adjusting the sputtering conditions.

### [Characteristics of sliding member of the present invention]

The sliding member of the present invention has the following characteristics in comparison with a sliding member of the related art.
(a) Ceramics with respect to DLC, particularly, a dry sliding couple of MgO-ZrO₂/α-Al₂O₃ have high load carrying capacity in low friction in air.
(b) The friction and the wear are low without depending on the sliding speed in a wide range of sliding speed which becomes two digits (0.03 m/s to 6 m/s) in naturally occurring environment on earth.
(c) The load carrying capacity is in the range of 100 MPa to 400 MPa and held up to the maximum of 6 m/s without depending on the sliding speed even though there are differences in degree.
(d) The PV value is extremely high and is in the range of 10 MPa·m/s to 1200 MPa·m/s. PV represents a boundary between a low friction state and a high friction state and also represents an upper limit in which a load loading material does not function properly when the value exceeds the upper limit.
(e) By a vapor deposition process, the surface roughness (RMS or Ra) can be made smaller than 5 nm without performing a finishing process of coating.
(f) Low friction and low wear can be realized even in an oxidizing atmosphere.

### Example 1

### [Friction test]

### [Sample]

Samples used in a friction test are as follows.
(a) Al₂O₃ has a purity of 99.7%, and Ra and RpK are respectively 0.033 µm and 0.019 µm.
(b) MgO-ZrO₂ contains 3.3% by weight of MgO and Ra is 0.028 µm.
(c) A sintered body was used for SiC.
(d) In a DLC thin film, an amorphous hard carbon film was made on a surface in which the surface of Cronidur 30 is polished so as to have Ra of less than 0.01 µm (Ra = C.L.A = center line average roughness) before vapor deposition of amorphous hard carbon. When the surface roughness was measured using a stylus type surface shape measuring device (stylus plofilometer) (HOMMEL T8000, stylus tip TKL100 with 60° and 2 µm) without performing machining and a surface treatment after vapor deposition, Rₐ, Rₚₖ, and Rᵥₖ were respectively 0.005 µm, 0.006 µm and 0.012 µm.

The surface roughness can be also calculated from a 2D topography image measured using an atomic force microscope (AFM) (manufactured by Asylum Corp.). RMS was 2.53 nm (0.00253 µm) and Rₐ was 1.98 nm (0.00198 µm) when the root mean square roughness (RMS) of the amorphous hard carbon coating (at the time of vapor deposition) was measured.

Further, sp³/(sp² + sp³) was 50 atomic% and the content of hydrogen was 16 atomic%.

Formation of a DLC thin film using sputtering was permade by the following operation.

A washed workpiece (X40CrMoN15-1, DIN: 1.4108; SAE AMS: 5898) was arranged in a UBM sputtering device and sputtering was permade using unbalanced magnetron sputtering (UBM) by argon (Ar) plasma. Methane and argon were used as a mixed system for a sputtering atmosphere, the ratio of argon to methane was set to 10.3, and a gas partial pressure was set to 0.4 Pa. A voltage applied to a target (sputtering power source voltage) and a bias voltage applied to the workpiece were direct currents (negative). The closest distance between the surface of the workpiece and the target was 15 cm and a film was made by sputtering. An inclined layer (film thickness: 0.2 µm) in which the composition ratio of chromium (Cr) was changed and a top layer (film thickness: 0.6 µm) of amorphous hard carbon (100%) were sequentially made on the workpiece (total film thickness: 0.8 µm). The bias voltage is maintained at 200 V from the start of film formation, but is dropped to 180 V during the formation of the top layer.

### [Friction measurement]

As a friction meter, a high-temperature friction meter in which BAM was designed was used in order to perform a sliding wear test in an unlubricated state in conformity with the previous DIN50324 (or ASTM G99). As the test concept designed by BAM, a toroid rather than a sphere was used as a stationary test sample. This is recommended by DIN 51834/ASTM G99. In the stationary sample on the spherical surface (R1 = 6 mm and R2 = 21 mm), the surface was polished and pressed against a coated plane of a rotating sample produced by Cronidur 30 (X40 CrMoN15-1, DIN: 1.4108; SAEAMS: 5898) during the test. Normal force of 10 N was applied thereto and, as a result, the initial Hertz pressure PH was 700 MPa to 1000 MPa in self combination ceramic.

The sliding distance between a pair of MgO-ZrO₂/DLC and a-Al₂O₃/DLC was 5000 m. The test was permade at 23°C in air. The sliding speed was 0.03, 0.1, 0.3, 1.0, 3.0, and 6.0 m/s and the relative humidity was in the range of 20% to 28%.

The calculated initial Hertz contact pressure was as follows when FN was 10 N in a combination of DLC and the following ceramics in the following test shape:
(a) MgO-ZrO₂/DLC; Pomax = 540 MPa
(b) a-Al₂O₃/DLC; Pomax = 620 MPa

Small coefficients of DLC were dominant as described above.

Continuous measurement was permade on the frictional force, the total linear wear, and the sample temperature. The wear volume was calculated from dimensions of wear scar and results of profilometry of wear track. As test samples, MgO-ZrO₂ was respectively combined with MgO-ZrO₂, α-Al₂O₃, and SSiC (sintered SiC) and the sliding distance of a comparative example test was 1000 m.

### Example 2

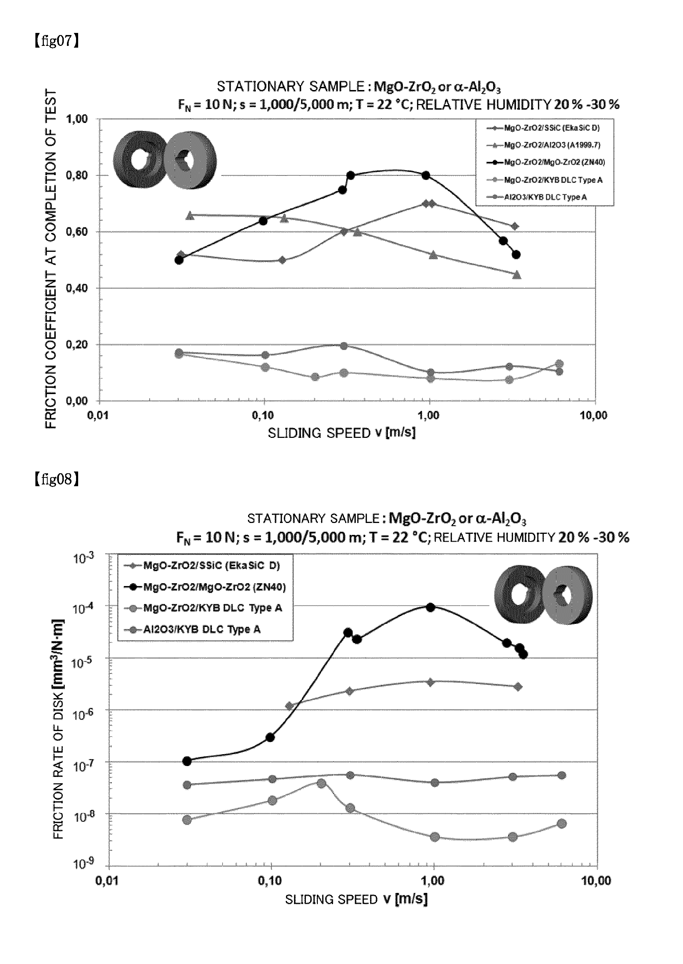

Continuous measurement was permade on the frictional force, the total linear wear, and the sample temperature. The wear volume was calculated from dimensions of wear scar and results of profilometry of wear track. Predetermined ceramics were combined and a test of a dry sliding couple was permade. As test samples, MgO-ZrO₂ was respectively combined with MgO-ZrO₂, α-Al₂O₃, and SSiC and the sliding distance of a test was 1000 m. The test was permade under the condition in which Ra of α-Al₂O₃ and SSiC was substantially the same as that of MgO-ZrO₂α-Al₂O₃. The test results of dry sliding are shown in Fig. 7.

A stationary sample (overlap ratio is 100%) of the sliding-couple is a sintered-ceramic monolithic body and is made of (a)MgO-ZrO₂ or (b) a-Al₂O₃ and a rotation sample is obtained through vapor deposition of thin film coating on the mating surface thereof.

In Fig. 7, as the friction coefficients of combined pairs of MgO-ZrO₂ and MgO-ZrO₂ (P₀ₘₐₓ = 602 MPa), a-Al₂O₃ (P₀ₘₐₛ = 713 MPa), or SSiC (P₀ₘₐₓ = 926 MPa) were greater than 0. 45, it cannot be said so lubricated. Further, the change in the friction coefficient was correlated with the sliding speed.

In a case of MgO-ZrO₂/amorphous hard carbon and a-Al₂O₃/amorphous hard carbon, the friction coefficient tends to be decreased when the sliding speed is increased from 0.03 m/s to 6 m/s, but it is understood that the friction coefficient maintains 0.20 or less regardless of the sliding speed.

An important advantage of the present invention is that the wear rate of the amorphous hard carbon thin film has no relation to the sliding speed. The dry running friction system becomes the same as an oil (fluid) lubrication system only in a case where wear and friction have almost no relation to the sliding speed. It is demonstrated that the present invention provides the solution.

### Example 3

Fig. 8 shows the change in the wear rate of a rotating counterbody (sliding-element 2, overlap ratio is less than 100%) as a function of the sliding speed. The wear rate of the amorphous hard carbon thin film tends to be decreased because of an increase in the sliding speed in the case of the pair of combination of MgO-ZrO₂/amorphous hard carbon. In the case of the pair of combination of a-Al₂O₃/ amorphous hard carbon, the wear rate of a thin film has completely no relation to the sliding speed. The test was permade under the condition of a relative humidity of 20% to 28%. Further, in order to examine the influence of the humidity, the dry sliding test was permade under the conditions of a sliding speed of 0.3 m/s at 23°C and a relative humidity of 99%. As a result, the friction coefficient was decreased and became 0.075, but the wear rate of the DLC thin film was not affected. kᵥ was 1.07 × 10⁻⁸ mm³/Nm and the value was the same as in the result of Fig. 8.

### Example 4

The contact pressure of 5000 m at the time of completion of the test was interesting. Wear Wq of area measurement described in ASTM D7755 was 5 µm² to 20 µm² in the case of the pair of the combination of MgO- ZrO₂/amorphous hard carbon and the wear depth of the DLC thin film was up to 0.1 µm. As a result which shows extremely low wear, the contact pressure does not almost change compared with the initial contact pressure because elastic deformation of the sliding-element is changed to a geometric contact pressure due to adaptive adjustment between two sliding-elements. A geometric contact shape P₀ₘₑₐₙ was calculated as 100 MPa to 200 MPa at the time of completion of the test. The P₀ₘₐₓ was 1.5 times the P₀ₘₑₐₙ.

The geometric contact pressure at the time of completion of the test is important because distribution of the initial contact pressure on the contact point is removed due to low friction measured in the DLC thin film and thus the state thereof becomes an adaptation contact state. As a result, the contact pressure is uniformly (or hydrostatically) distributed in the same manner as that of the geometric contact pressure.

The product of the sliding speed of 0.03 m/s to 6 m/s related to a contact pressure P₀ₘₑₐₙ of 100 MPa to 200 MPa at the time of completion of the test becomes an extremely high PV value and becomes 1200 MPaXm/s at most. The PV value is far greater than the range of the current state-of-the-art technology in the dry sliding. The PV value is far greater than the range of 40 MPaXm/s to 70 MPaXm/s of sintered bronze or the range of 15 MPaXm/s to 30 MPaXm/s of sintered iron which is the range of the current state-of-the-art technology in the dry sliding.

### [Description of used terms]

### [PV value and PV coefficient]

The PV coefficient and the P×V value are products of the bearing pressure and the surface velocity (pure sliding) and are represented by (lb/in²) × (ft/min), but corresponds to PaXm/s in ISO. This positions the mechanical input of the sliding bearing as the largest mechanical input in which severity of design or a sliding member can support. The limit of PV seems to reflect that heat is generated by friction of two surfaces. The term of µPV corresponds to heat being generated (or mechanical work) (W/mm2). Dissipating energy passes through the contact surface and diffuses into dry friction (unlubricated) or the volume of the lower portion of mixed lubrication/boundary lubrication.

Further, P×V represents a boundary between the low wear state and the high wear state as well as the upper limit of the PV product in which a load loading material does not function properly when the value exceeds the upper limit. The maximum allowable P×V is approximation useful when a sliding-couple is used in the design in a case of no lubrication contact particularly.

### [Wear rate]

According to the previous DIN50321, the wear can be quantified by a change in the dimension, the weight, or the volume and can be standardized in the operating conditions. The wear rate is defined as "rate of material removal or dimensional change due to wear per unit, for example, per unit distance of sliding." The internationally used volumetic wear rate or wear coefficient [mm³/Nm], (see DIN50324, ASTM G99) represents a prediction of wear of pairs under a certain operation conditions, but this is not a property of the material. This is defined as a ratio obtained by dividing the wear volume by an actual vertical force and an effective sliding distance. The internationally used unit is normally [mm³/Nm].

According to a working group of the OECD, the state-of-the-art wear rate is established in BAM in 1901 and three friction states of the well-known Stribeck curve is correlated with the wear rate of metal. In mixed lubrication/boundary lubrication and continuous sliding, the standard wear rate is generally in the range of 10⁻⁷ to 10⁻⁹ [mm³/Nm] and is smaller than 10⁻⁹ [mm³/Nm] in elastic fluid lubrication (EHL). It is rare that the wear rate in dry friction becomes 10⁻⁸ [mm³/Nm] in ceramic and 10⁻⁶ or less [mm³/Nm] in metal and a polymer. A wear rate of 10⁻⁸ [mm³/Nm] represents that materials are reduced in a fine contact having only one atomic layer by every operation, but it is unlikely to happen. With this concept, the boundary line between the dry friction and the liquid mixing/boundary lubrication is easily understood, but the present invention is surprisingly beyond this.

### [No wear]

A plurality of elements which are required for the "zero wear" state can be assumed, and two or more of (a) to (c) below are necessary.
(a) A smooth surface in an atomic level
(b) Small surface interaction
(c) Elastically demade fine irregularities

### [Lubricity]

The lubricity has become the center of worldwide research related to low friction. The lubricity is somewhat commonly used because the lubricity expresses low friction and high wear resistance. The engineering science and technology dictionary of American Society for Testing and Materials (ASTM) describes the lubricity as a "qualitative term that expresses the ability of a lubricant for minimize friction and damage on the surface in a relative movement under load." In the dry sliding, a friction coefficient of less than 0.01 appears from the year of 1995 and this is evaluated as "super lubricity." Unfortunately, a vacuum or a nitrogen atmosphere is required for this because a sliding-element (mainly the coating) is easily oxidized. On the contrary, the present invention provides a sliding-couple with low friction and extremely low wear in naturally occurring environment on earth.

### Industrial Applicability

Since a slidingsystem of the present invention has low wear, particles are unlikely to be generated due to the wear. Further, because of dry sliding (a lubricant is not used), it is possible to prevent contamination from a lubricant. By applying these advantages, it can be applied to any low friction of mechanical components in which friction is inevitably generated. Further, when used in an atmosphere containing oxygen, actual operations through fill valves, shut-off valves, residual pressure valves, regulators, or safety valves in medical or industrial equipment and the safety can be secured.

For example, microelectronics or chips are easily affected by contamination of particles, dust, or aerosols, but particles are generated due to friction of equipment or mechanical devices in a clean room and steam of a chemical substance or aerosols are generated by a lubricant or a fluid. The present invention, as a slidingsystem without a lubricant, can improve the environment in a clean room, minimize the air pollution, and prevent fire caused by fine particles in the presence of oxygen. The present invention can be applied to devices in machinery and equipment in which adiabatic compression, resonance, solid friction, or fluid friction cannot be avoided.

### Reference Signs List

1: Base material
2: Inclined layer
3: Amorphous hard carbon film

## Claims

1. A sliding member comprising:
a sliding-element 1; and
a sliding-element 2 which serves as a counterbody to the sliding-element 1,
wherein the sliding-element 1 includes a sliding-surface made of oxide ceramics, and
the sliding-element 2 includes a sliding-surface made of a thin film containing hydrogen and sp³/ sp²-hybridized carbon.

2. The sliding member according to claim 1, wherein tribological overlap ratios of the sliding-element 1 and the sliding-element 2 are 100% in the sliding-element 1 and less than 100% in the sliding-element 2.

3. The sliding member according to claim 1, wherein the oxide ceramics of the sliding-element 1 are a monolithic body or a thin film.

4. The sliding member according to claim 1, wherein the oxide ceramics of the sliding-element 1 are made of one or more of the oxide ceramics selected from stabilized zirconia, titanium dioxide containing titania of Magneli phase, alumina, and zirconia-toughened alumina.

5. The sliding member according to claim 1, wherein the sliding-surface of the sliding-element 1 has a surface roughness Ra of 2.0 µm or less.

6. The sliding member according to claim 1,
wherein the thin film of the sliding-element 2 is made of hydrogen and sp³/sp²-hybridized carbon, and
sp³/(sp² + sp³) is greater than 40 atomic%.

7. The sliding member according to claim 1, wherein the thin film of the sliding-element 2 is made of amorphous hard carbon containing hydrogenated amorphous carbon.

8. The sliding member according to claim 1, wherein the sliding-surface of the sliding-element 2 has a surface roughness Ra of 2.0 µm or less.

9. The sliding member according to claim 1, wherein the sliding-element 2 includes a metal base material selected from iron, steel, an iron alloy, aluminum, or an aluminum alloy, and a thin film made on the surface thereof.

10. The sliding member according to claim 1, wherein the thin film of the sliding-element 2 includes an inclined layer which contains metal and the content thereof is decreased toward the surface, and a surface layer is made of hydrogen and sp³/sp²-hybridized carbon.

11. The sliding member according to claim 1, wherein the thin film of the sliding-element 2 includes an inclined layer which includes one or more metals selected from chromium, tungsten, and titanium and the content thereof is decreased toward the surface and a surface layer is made of hydrogen and sp³/sp²-hybridized carbon.

12. The sliding member according to claim 1 wherein the sliding member has properties that a friction rate or a wear rate does not depend on sliding speed.

13. The sliding member according to claim 1 wherein the sliding member exhibits low friction properties and low wearing properties in an oxidizing atmosphere.
